(19) Europäisches Patentamt / European Patent Office / Office européen des brevets

(11) **EP 3 632 838 B1**

(12) **FASCICULE DE BREVET EUROPEEN**

(45) Date de publication et mention
de la délivrance du brevet:
**30.06.2021 Bulletin 2021/26**

(51) Int Cl.:
***B81B 3/00*** *(2006.01)*

(21) Numéro de dépôt: **19200873.8**

(22) Date de dépôt: **01.10.2019**

(54) **CAPTEUR MICROELECTRONIQUE A DETECTION HORS-PLAN OFFRANT UNE SENSIBILITE TRANSVERSE MAITRISEE**

MIKROELEKTRONISCHER SENSOR ZUR ERKENNUNG VON ABWEICHUNGEN, DER EINE KONTROLLIERTE QUEREMPFINDLICHKEIT AUFWEIST

MICROELECTRONIC SENSOR WITH OUT-OF-PLANE DETECTION PROVIDING A CONTROLLED CROSS SENSITIVITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.10.2018 FR 1859118**

(43) Date de publication de la demande:
**08.04.2020 Bulletin 2020/15**

(73) Titulaire: **Commissariat à l'énergie atomique et aux énergies alternatives 75015 Paris (FR)**

(72) Inventeurs:
• **JOET, Loïc**
**38054 Grenoble Cedex 09 (FR)**
• **REY, Patrice**
**38054 Grenoble Cedex 09 (FR)**

(74) Mandataire: **Brevalex**
**95, rue d'Amsterdam**
**75378 Paris Cedex 8 (FR)**

(56) Documents cités:
**EP-A1- 2 211 185**

**Description**

**DOMAINE TECHNIQUE ET ÉTAT DE LA TECHNIQUE ANTÉRIEURE**

La présente invention se rapporte à un capteur à structure microélectromécanique et nanoélectromécanique ou MEMS&NEMS (microelectromechanical and nanoelectromechanical systems en terminologie anglo-saxonne) à détection hors plan.

Les capteurs MEMS&NEMS à détection hors plan sont par exemple utilisés pour réaliser des accéléromètres, des gyromètres, des capteurs de force ou de champ magnétique. Ils comportent une masse suspendue par rapport à un support, qui est destinée à avoir un déplacement hors-plan, i.e. sensiblement orthogonal au plan du capteur, sous l'effet d'une force extérieure par exemple une accélération ou une force de Coriolis.

Le document FR 3 000 050 décrit un dispositif microélectromécanique utilisé comme capteur de force, comportant une masse suspendue à un support par au moins une poutre destinée à se déformer en flexion et des poutres destinées à se déformer en torsion. Les poutres définissent un axe de rotation et la masse pivote autour de cet axe sous l'effet d'une force extérieure. Des jauges piézorésistives sont suspendues entre le support et la masse mobile, chacune est sollicitée en traction ou en compression. La résistance électrique des jauges varie proportionnellement à la contrainte appliquée à la masse et un signal est émis par les jauges, cette variation étant représentative du déplacement hors-plan de la masse.

Afin d'offrir un capteur performant, on cherche à réaliser un capteur présentant une sensibilité élevée dans la direction hors-plan, désignée ici sensibilité, et une sensibilité faible, voire une insensibilité, dans les directions du plan.

Les poutres de flexion du capteur du document FR3 000 050 s'étendent dans une direction orthogonale à la direction hors-plan et à l'axe du pivot. Elles présentent une grande rigidité dans cette direction, ce qui a pour effet de réduire sensiblement la sensibilité transverse dans cette direction, cependant elles ont également pour effet de diminuer la sensibilité dans la direction hors-plan.

Le document EP 2211 185 décrit un capteur MEMS comportant une masse mobile épaisse, des poutres de suspension d'épaisseur inférieure ou égale à celle de la masse et des jauges de détection d'épaisseur inférieure aux poutres de suspension. Lorsque le capteur est soumis par exemple à une force dans une direction orthogonale à la direction hors-plan et à l'axe du pivot, d'une part la force exerce :

- une contrainte (traction ou compression suivant le sens de la force) sur les poutres de suspension,
- une traction sur une première jauge et une compression sur une deuxième jauge, ce qui induit une élongation ou un rétrécissement des jauges.

D'autre part, les forces appliquées ne sont pas coplanaires, il en résulte un couple exercé sur la masse qui a un effet inverse sur les jauges (compression de la première jauge et traction sur la deuxième jauge). Ces effets ne se compensent pas en général, il en résulte une contrainte différentielle non nulle dans les jauges et donc une sensibilité du capteur à une sollicitation dans la direction orthogonale à la direction hors-plan et à l'axe du pivot.

En outre cette sensibilité transverse n'est pas maîtrisée.

Il est possible de s'affranchir de cette sensibilité parasite, dans le cas où le capteur à détection hors-plan est associé à au moins un capteur à détection dans la direction transverse, en effet dans ce cas l'erreur due à la sensibilité parasite peut être corrigée, cependant cette solution impose la mise en œuvre d'un deuxième capteur, ce qui augmente le coût de revient et l'encombrement, et il en résulte une complexification de l'électronique requise.

**EXPOSÉ DE L'INVENTION**

C'est par conséquent un but de la présente invention d'offrir un capteur microélectromécanique et nanoélectromécanique offrant à la fois une grande sensibilité dans la direction hors plan et une sensibilité transverse maîtrisée de manière simple.

Le but énoncé ci-dessus est atteint par un capteur microélectromécanique tel que défini à la revendication 1, celui-ci comportant une structure comprenant une masse suspendue à un support par des moyens de suspension de sorte à être mobile selon une direction hors-plan, lesdits moyens de suspension comportant au moins une poutre sollicitée en flexion. Le capteur comporte également des moyens de détection du déplacement hors-plan de la masse, comprenant au moins une jauge de contrainte suspendue entre le support et la masse et s'étendant orthogonalement à l'axe de rotation. L'épaisseur d'au moins la poutre de flexion est alors choisie par rapport à l'épaisseur de la masse, en fonction de la sensibilité transverse qui est acceptée pour le capteur.

En effet, les inventeurs ont déterminé, de manière surprenante, qu'il était relativement aisé de maîtriser la valeur de la sensibilité transverse en choisissant de manière adéquate les épaisseurs des poutres sollicitées en flexion et de la masse. Ils ont déterminé que l'épaisseur de la ou des poutres sollicitées en flexion $t_f$ pouvait être reliée à l'épaisseur de la masse $t_M$ et à la sensibilité transverse souhaitée $S_T$ par la relation suivante :

$$t_f = \frac{3}{4}(t_M - 2l_{arm}S_T)$$

Avec $l_{arm}$ : distance du centre de gravité de la masse sismique et le centre de la ou des poutres sollicitées en flexion projeté sur la première direction longitudinale.

Ainsi, il est possible de déterminer la structure du capteur pour qu'il présente les spécifications attendues en termes de sensibilité transverse.

La masse est sollicitée autour de deux axes de rotation différents suivant que la sollicitation est dans la direction hors-plan ou dans une direction contenue dans le plan. Les inventeurs ont déterminé qu'ils pouvaient concevoir une structure de telle sorte que l'axe de rotation de la structure, lorsqu'elle est soumise à un effort dans le plan, se rapproche du plan milieu de la ou de jauges de contrainte. Plus cet axe est proche du plan milieu des jauges, plus la somme des contraintes dans le plan vue par les jauges est réduite. La sensibilité transverse de la structure est de ce fait réduite. De manière préférée l'axe de rotation de la structure, lorsqu'elle est soumise à une contrainte dans le plan, est déplacé de sorte à se trouver dans le plan milieu des jauges pour annuler complètement la somme des contraintes vue par celles-ci. Les jauges ne subissent alors pas d'extension.

On entend par « plan milieu », un plan parallèle au plan dans lequel s'étend la structure, i.e. le plan XY, et situé à égale distance des extrémités de la jauge dans la direction hors-plan.

De manière préférée, la sensibilité transverse recherchée est au plus de 1%.

De manière très avantageuse, en choisissant une ou des poutres de flexion ayant une épaisseur égale à 3/4 de l'épaisseur de la masse, le capteur MEMS présente une sensibilité transverse nulle.

Grâce à l'invention, il est donc possible de maîtriser voire d'éviter l'erreur due à la sensibilité transverse du capteur sans mettre en œuvre un deuxième capteur.

La présente invention a alors pour objet un capteur microélectromécanique à détection hors-plan présentant une sensibilité transverse de valeur $S_T$ selon, une première direction dans le plan, ledit capteur comportant un support, une masse inertielle suspendue au support par des moyens de suspension, un premier axe de rotation autour duquel la masse inertielle pivote par rapport au support dans une direction hors-plan lorsque le capteur est soumis à une contrainte dans la direction hors-plan, lesdits moyens de suspension comportant au moins une première poutre s'étendant dans le plan du capteur, ladite au moins une première poutre étant ancrée par une extrémité longitudinale au support et par une autre extrémité longitudinale à la masse inertielle, de sorte que lors d'un déplacement de la masse inertielle dans la direction hors-plan, ladite au moins première poutre soit sollicitée en flexion, et des moyens de détection du déplacement de la masse dans la direction hors plan, lesdits moyens de détection comportant au moins une première jauge de contrainte suspendue par une première extrémité à la masse inertielle et par une deuxième extrémité au support et s'étendant parallèlement à ladite au moins une première poutre, dans lequel ladite au première poutre a une dimension $t_f$ dans la direction hors-plan et la masse inertielle a une dimension $t_M$ dans la direction hors-plan telles que

$$t_f = \frac{3}{4}(t_M - 2l_{arm}S_T).$$

$l_{arm}$ étant la distance entre le centre de gravité de la masse inertielle et le centre de la au moins une première poutre projeté sur la première direction longitudinale.

De manière très avantageuse, la dimension dans la direction hors-plan tf de la première poutre est choisie égale à 3/4 de la dimension dans la direction hors-plan $t_M$ de la masse de sorte que le capteur présente une sensibilité transverse de valeur $S_T$ nulle ou quasiment nulle.

Dans un exemple de réalisation, les moyens de suspension comportent au moins deux premières poutres.

Selon une caractéristique additionnelle, les moyens de suspension peuvent comporter au moins une deuxième poutre et destinée à être sollicitée en torsion lors du déplacement de la masse inertielle dans la direction hors-plan.

Selon une caractéristique additionnelle, le capteur comporte un deuxième axe de rotation autour duquel la masse inertielle pivote par rapport au support dans une direction hors-plan lorsque le capteur est soumis à une contrainte dans la direction dans le plan. Le deuxième axe de rotation est avantageusement est située dans le plan milieu de la première jauge.

De préférence, la sensibilité transverse est comprise dans l'intervalle [-1% ; +1%].

Les moyens de détection peuvent comporter une deuxième jauge de contrainte suspendue et disposé par rapport à la première jauge de sorte à permettre une mesure différentielle.

La présente invention a également pour objet un procédé de fabrication d'un capteur selon selon la revendication 8, comportant :

- la réalisation d'au moins une première jauge de contrainte dans une première couche conductrice électrique ou semi-conductrice, formée sur une couche d'arrêt formée sur une couche support
- la formation d'un couche de protection uniquement sur ladite au moins une première jauge de contrainte,
- la formation d'une deuxième couche conductrice électrique ou semi-conductrice sur la première couche et sur la couche de protection, de sorte que l'épaisseur de la première et de la deuxième couche soit égale à l'épaisseur de la masse inertielle $t_M$,
- la formation d'un premier masque pour définir la masse inertielle,
- la formation d'un deuxième masque à l'aplomb de l'emplacement de la au moins première poutre,
- la structuration des première et deuxième couches conductrices électriques ou semi-conductrices de sorte à délimiter la masse inertielle et atteindre la couche de protection de la au moins une première jauge,
- le retrait du deuxième masque,
- l'amincissement de la deuxième couche conductrice électrique ou semi-conductrice de sorte à retirer une épaisseur de matériau conducteur ou semi-conducteur égale à $t_M - t_f$,
- la libération de la masse inertielle, de la au moins une première jauge et de la au moins première poutre.

La présente invention a également pour objet un procédé de fabrication d'un capteur selon selon la revendication 9, comportant :

- la réalisation d'au moins une première jauge de contrainte dans une première couche conductrice électrique ou semi-conductrice, formée sur une couche d'arrêt formé sur une couche support
- la formation d'un couche de protection uniquement sur ladite au moins une première jauge de contrainte,
- la formation d'une deuxième couche conductrice électrique ou semi-conductrice sur la première couche et sur la couche de protection, de sorte que l'épaisseur de la première et de la deuxième couche soit égale à l'épaisseur de la première poutre $t_f$,
- la formation d'une portion d'arrêt sur la deuxième couche conductrice électrique ou semi-conductrice à l'aplomb de l'emplacement de la au moins première poutre,
- la formation d'une troisième couche conductrice électrique ou semi-conductrice sur la deuxième couche conductrice électrique ou semi-conductrice et sur la portion d'arrêt, de sorte que l'épaisseur de la première, de la deuxième et de la troisième couche soit égale à l'épaisseur de la masse inertielle $t_M$,
- la formation d'un premier masque pour définir la masse inertielle et un deuxième masque à l'aplomb de la portion d'arrêt,
- la structuration des première, deuxième et troisième couches conductrices électriques ou semi-conductrices de sorte à délimiter la masse inertielle et atteindre la couche de protection de la au moins une première jauge,
- le retrait du deuxième masque,
- l'amincissement de la deuxième couche conductrice électrique ou semi-conductrice de sorte à retirer une épaisseur de matériau conducteur ou semi-conducteur égale à $t_M - t_f$,
- la libération de la masse inertielle, de la au moins une première jauge et de la au moins première poutre.

Par exemple, le premier masque est en oxyde et le deuxième masque est en résine.
La deuxième couche et la troisième couche peuvent être formées par épitaxie.

## BRÈVE DESCRIPTION DES DESSINS

La présente invention sera mieux comprise sur la base de la description qui va suivre et des dessins en annexe sur lesquels:

- les figures 1 et 2 sont des vues de dessus et de côté respectivement d'un autre exemple de capteur MEMS & NEMS à détection hors-plan auquel s'applique l'invention,
- la figure 3 est une représentation schématique du capteur des figures 1 et 2 subissant une accélération selon la direction X,
- la figure 4 est une représentation schématique du capteur des figures 1 et 2 subissant une accélération selon la direction Z
- les figures 5A à 5E sont des images provenant d'une simulation par éléments finis de la structure des figures 1 et 2 vue de côté et montrant la localisation de l'axe de rotation en fonction de l'épaisseur des poutres de flexion,
- la figure 6 est une représentation graphique de la variation de la sensibilité transverse $S_T$ en fonction de l'épaisseur des poutres de flexion $t_f$,

- la figure 7 est une représentation graphique de la variation de la masse normalisée de la masse inertielle en fonction de l'épaisseur des poutres de flexion $t_f$,
- les figures 8A à 8I sont des représentations schématiques d'étapes d'un exemple de procédé de réalisation d'un capteur à sensibilité maitrisée,
- les figures 9A à 9K sont des représentations schématiques d'étapes d'un exemple de procédé de réalisation d'un capteur à sensibilité maîtrisée.

## EXPOSÉ DÉTAILLÉ DE MODES DE RÉALISATION PARTICULIERS

La présente invention s'applique aux capteurs inertiels à structure microélectromécanique et nanoélectromécanique ou MEMS&NEMS ou encore M&NEMS, i.e. comportant des éléments de taille micrométrique, tels que la masse et les poutres de suspension de la masse, et des éléments de taille nanométrique, tels que les jauges de contrainte. A des fins de simplicité, on désignera par « capteur microélectromécanique » un capteur comportant à la fois un ou des éléments microélectromécaniques et un ou des éléments nanoélectromécaniques.

Le plan du capteur est le plan dans lequel s'étend le capteur qui est parallèle au substrat à partir duquel le capteur est fabriqué. Les directions du plan sont désignées X et Y et la direction hors-plan désignée Z est orthogonale au plan du capteur et aux directions X et Y.

En outre les capteurs sont des capteurs inertiels à détection hors-plan, i.e. destinés à détecter une grandeur dans la direction hors-plan Z. Les capteurs comportent au moins une masse qui est destinée à être mise en mouvement dans la direction hors-plan sous l'effet d'une force résultant de la grandeur à détecter, telle que l'accélération, les forces de Coriolis, un champ magnétique, une force....

La présente invention permet de réaliser des capteurs M&NEMS à détection hors-plan présentant une sensibilité transverse maîtrisée. On entend par « sensibilité transverse » ou « sensibilité parasite », la sensibilité du capteur, i.e. la sensibilité des moyens de détection, à une grandeur selon une direction orthogonale à la direction hors-plan Z et à la direction dans le plan autour de laquelle la masse est articulée, cette direction est désignée X. On désignera par « sensibilité » la sensibilité du capteur à détection hors-plan, à la grandeur dans la direction hors-plan, i.e. à la grandeur à détecter pour laquelle le capteur est conçu.

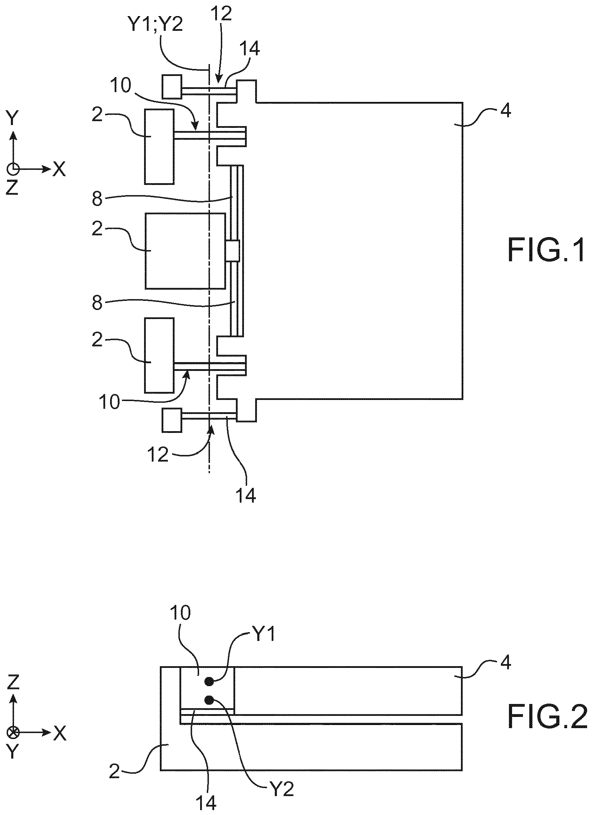

Sur les figures 1 et 2, on peut voir une vue de dessus et une vue de côté respectivement d'un capteur microélectromécanique à détection hors-plan auquel s'applique l'invention.

Le capteur comporte un support 2 s'étendant dans un plan XY, une masse 4 suspendue par rapport au support 2 de sorte à être mobile par rapport au support dans la direction hors-plan Z.

La masse 4 est suspendue au support 2 par des moyens d'articulation 6 en rotation.

Les moyens d'articulation 6 comportent, dans l'exemple représenté, deux poutres 8 s'étendant dans la direction Y. Chaque poutre 8 est d'une part ancrée, par une première extrémité longitudinale, à la masse et, par une deuxième extrémité longitudinale, au support. Les poutres 8 sont destinées à se déformer en torsion, lorsque la masse est mise en mouvement. Les poutres 8 assurent un maintien dans la direction Y.

Les moyens d'articulation comportent également deux deuxièmes poutres 10 s'étendant orthogonalement à l'axe Y et ancrées par une première extrémité à la masse et par une deuxième extrémité au support. Les deuxièmes poutres 10 sont destinées à être sollicitées en flexion.

Lorsque la masse est soumise à une contrainte selon Z, elle se déplace en rotation par rapport au support 2 autour d'un premier axe pivot Y1 parallèle à la direction Y. Lorsque la masse 4 est soumise à une contrainte selon X, elle se déplace en rotation par rapport au support autour d'un deuxième axe pivot Y2 parallèle la direction Y.

Le capteur comporte également des moyens de détection 12 du déplacement de la masse, comprenant au moins une jauge de contrainte 14 suspendue entre la masse et le support de sorte à subir une contrainte en traction ou de compression, lorsque la masse se déplace autour de l'axe Y1. De manière préférée, les moyens de détection 12 comportent deux jauges de contrainte 14 montées en différentiel de sorte que, lorsqu'une jauge est sollicitée en traction, l'autre jauge est sollicitée en compression.

Les jauges de contrainte sont par exemple des jauges piézorésistives ou piézoélectriques.

Dans l'exemple représenté, les jauges sont disposées en alignement de la face des poutres de flexion 10 et de la masse en regard du support.

Les emplacements du premier axe pivot Y1 et du deuxième axe pivot Y2 dépendent des raideurs des poutres de flexion et des jauges et de leur épaisseur.

Sur les figures 1 et 2, les axes Y1 et Y2 sont représentés uniquement à titre d'illustration.

Grâce à l'invention, les deuxièmes poutres sollicitées en flexion et la masse sont dimensionnées de sorte que la sensibilité transverse $S_T$ ou sensibilité parasite soit maîtrisée.

Les inventeurs ont déterminé qu'une relation pouvait être établie entre l'épaisseur de la masse, l'épaisseur des poutres sollicitées en flexion et la sensibilité parasite, pour réaliser une structure de capteur présentant une sensibilité parasite de valeur donnée, qui peut être nulle.

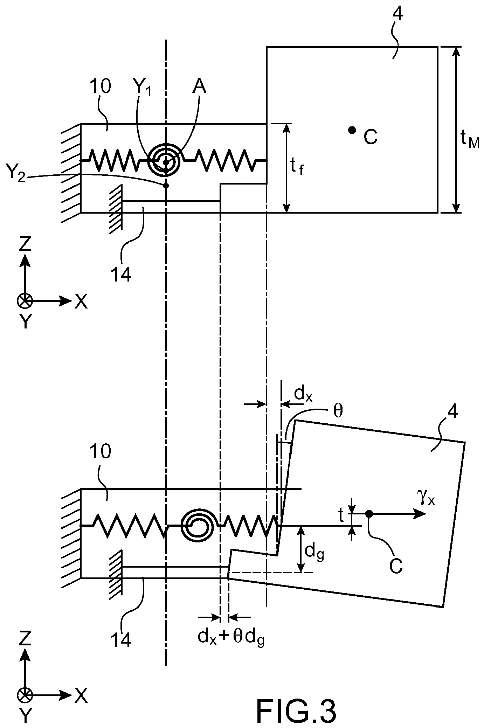

Sur la figure 3, on peut voir un capteur proche de celui des figures 1 et 2 soumis à une accélération $\gamma_x$ selon la direction X.

θ est l'angle de rotation de la masse par rapport au plan YZ et δx est le déplacement de la masse dans la direction X sous l'effet de l'accélération $\gamma_x$. La translation de la mase est exprimée au milieu des poutres de flexions

Les poutres de torsion engendrent une raideur hors plan telle que le déplacement en Z est considéré négligeable. Inversement, leur raideur en X est considérée négligeable et elles ne seront pas prises en compte dans le bilan des forces ci-dessous.

On se place dans le cas où θ est petit.

Dans le cas où θ est grand, les expressions seraient différentes mais la relation entre les épaisseurs de la masse et des poutres de flexion est la même.

Lorsque la structure est soumise à une accélération $\gamma_x$ suivant la direction X, elle est soumise aux forces suivantes :

Une force d'inertie : $F_i = m\gamma_x$,
m étant la masse de la masse inertielle.

Une force de rappel des poutres de flexion appliquée par les poutres de flexion : $F_{rf} = k_f \delta x$, avec $k_f$ la raideur des deux poutres 14'.

Une force de rappel de la jauge : $F_{rg} = k_g(\delta x + \theta d_g)$, avec $k_g$ la raideur de la jauge.

$d_g$ est la distance entre le milieu des poutres de flexion et le plan milieu XY des jauges, dans la direction Z.

En écrivant l'équilibre des forces et l'équilibre des moments au point A, on obtient le système :

$$m\gamma_x - k_f \delta x - k_g(\delta x + \theta d_g) = 0 \quad (1)$$

$$m\gamma_x t + C_s \theta + k_g(\delta x + \theta d_g)d_g = 0$$

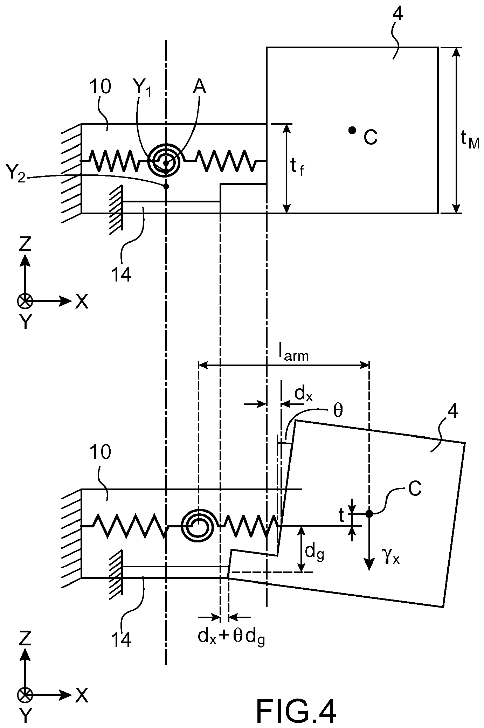

Avec $C_S$ la constante de rappel en rotation (ou raideur angulaire) des poutres de flexion, et t la distance entre les deux plans XY contenant respectivement le centre de gravité C de la masse et le premier axe de rotation Y1. Il est à noter que dans le cas de la structure représentée sur les figures 3 et 4, dans laquelle le plan milieu des poutres de flexion est confondu avec celui des jauges, les axes de rotation Y1 et Y2 se trouvent dans le plan YZ passant par le milieu des poutres de flexion et des jauges.

Du système d'équation (1), on calcule l'expression de l'allongement de la jauge lorsque la structure est soumise à une accélération suivant l'axe X :

$$\delta x + d_g \theta = m\gamma_x \frac{\dfrac{1}{k_f} - d_g \dfrac{t}{C_s}}{1 + \dfrac{k_g}{k_f} + \dfrac{k_g d_g^2}{C_s}}$$

On calcule ensuite la force exercée sur la jauge, qui est égale au produit de sa raideur par son allongement :

$$F_{gau} = k_g(\delta x + d_g \theta) = m\gamma_x \frac{\dfrac{1}{k_f} - t\dfrac{d_g}{C_s}}{\dfrac{1}{k_g} + \dfrac{1}{k_f} + \dfrac{d_g^2}{C_s}}$$

Sur la figure 4, on peut voir le capteur des figures 1 et 2 soumis à une accélération selon Z.

Le bilan des forces et des moments s'écrit alors :

$$0 = k_f \delta x + k_g(\delta x + \theta d_g)$$

$$-m\gamma_z l_{arm} = C_s\theta + k_g\big(\delta x + \theta d_g\big)d_g$$

Avec $l_{arm}$ : distance dans le plan entre le centre de gravité C de la masse sismique et le centre des poutres de flexion projeté sur X. La valeur de $l_{arm}$ est fixée lors de la conception du capteur, les dimensions du capteur dans le plan étant fixées. Puisque l'on travaille en petits signaux, l'allongement des poutres de flexion est négligeable lors du déplacement de la masse.

$$F_{gau} = k_g\big(\delta x + d_g\theta\big) = -m\gamma_z l_{arm}\frac{d_g}{C_s}\frac{1}{\frac{1}{k_g} + \frac{1}{k_f} + \frac{d_g^2}{C_s}}$$

La sensibilité transverse $S_T$ s'exprime généralement en pourcentage de la sensibilité axiale.
On définit alors la sensibilité transverse par :

$$S_T = \frac{\left(\frac{F_{gau}}{\gamma_x}\right)}{\left(\frac{F_{gau}}{\gamma_z}\right)} = \frac{\frac{1}{k_f} - t\frac{d_g}{C_s}}{-l_{arm}\frac{d_g}{C_s}} = \frac{d_g}{l_{arm}}\left(\frac{t}{d_g} - \frac{C_s}{k_f d_g^2}\right) = \frac{1}{\Gamma}\left(\frac{t}{d_g} - \frac{C_s}{k_f d_g^2}\right)$$

Avec $\Gamma = \frac{d_g}{l_{arm}} = \frac{t_f}{2l_{arm}}$ : bras de levier de la structure en négligeant l'épaisseur de la jauge.
Le modèle de poutre de Bernoulli permet d'exprimer les raideurs en fonction du module de Young et de leur géométrie:

$$\left.\begin{array}{l} k_f = E\dfrac{w_f t_f}{l_f} \\[3mm] C_s = \dfrac{E}{3}\dfrac{w_f t_f^3}{l_f} \end{array}\right\} => \frac{C_s}{k_f} = \frac{t_f^2}{3}$$

La distance pivot jauge peut elle aussi être exprimée en fonction de la géométrie des poutres

$$d_g = \frac{t_f}{2} - \frac{t_g}{2} \approx \frac{t_f}{2}$$

D'où :

$$S_T = \frac{1}{\Gamma}\left(\frac{t_M}{t_f} - \frac{4}{3}\right) = \frac{1}{2l_{arm}}\left(t_M - \frac{4}{3}t_f\right) \ (2)$$

Ainsi, la sensibilité transverse ne dépend que du bras de levier de la structure et du rapport des épaisseurs de la masse et des bras de flexion.

Cette sensibilité transverse s'annule pour $t_f = \frac{3}{4}t_M$. Ainsi il est possible de définir une structure de capteur à détection hors-plan présentant une sensibilité transverse nulle aux approximations près dues aux hypothèses de calcul, ce qui signifie que dans une structure ainsi dimensionnée la jauge ne subit aucune élongation selon X, lorsqu'une accélération suivant la direction X est appliquée. En effet, en choisissant un tel rapport, le deuxième axe de rotation de la structure Y2, lors d'une sollicitation dans le plan, se trouve dans le plan milieu des jauges la somme des contraintes est alors nulle. Dans le cas particulier des figures 3 et 4, il se trouve au milieu des jauges, les jauges subissent alors une flexion pure. Lorsque l'axe Y2 est en bout de jauge, celle-ci est plus contrainte mais la somme des contraintes selon X est toujours nulle.

Généralement, des spécifications en termes de sensibilité transverse sont fixées pour chaque modèle de capteur.

Grâce à l'invention, connaissant la valeur de $S_T$ spécifiée il est possible de définir quelles sont les épaisseurs des poutres de flexion et de la masse à choisir, pour obtenir un capteur de sensibilité $S_T$.

En effet, à partir de la relation (2), on peut écrire :

$$t_f = \frac{3}{4}(t_M - 2l_{arm}S_T) \ (3).$$

A titre d'exemple, la spécification sur la sensibilité transverse maximale est en général inférieure à 1 %. Ainsi, pour $S_{Tmax}$ = +/-0.5%, $t_M$ = 20 $\mu m$ et $l_{arm}$ = 246$\mu m$, on peut déterminer $t_f$.

$$13,1 \ \mu m < t_f < 16,8 \ \mu m$$

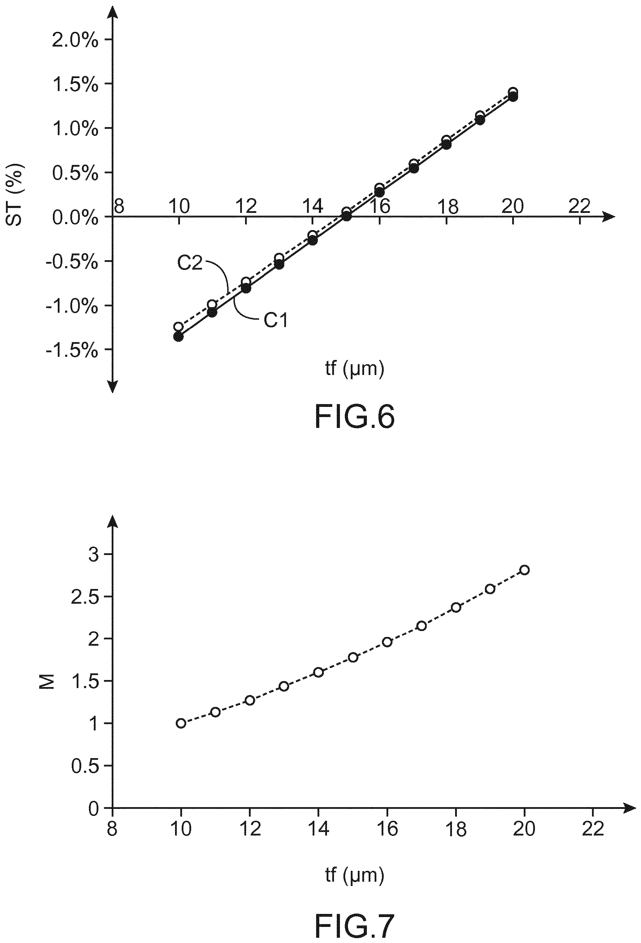

Sur la figure 6, est représentée la variation de la sensibilité transverse, en %/$\mu$N, en fonction de l'épaisseur $t_f$, en $\mu m$, des poutres de flexion pour une masse d'épaisseur 20 $\mu m$, calculée à partir de la relation (II) (courbe C1) et à partir d'une simulation par éléments finis (courbe C2).

On constate un bon accord entre le modèle analytique établi par les inventeurs et la simulation par éléments finis. La sensibilité $S_T$ s'annule pour $t_f$ = 14,6 $\mu m$.

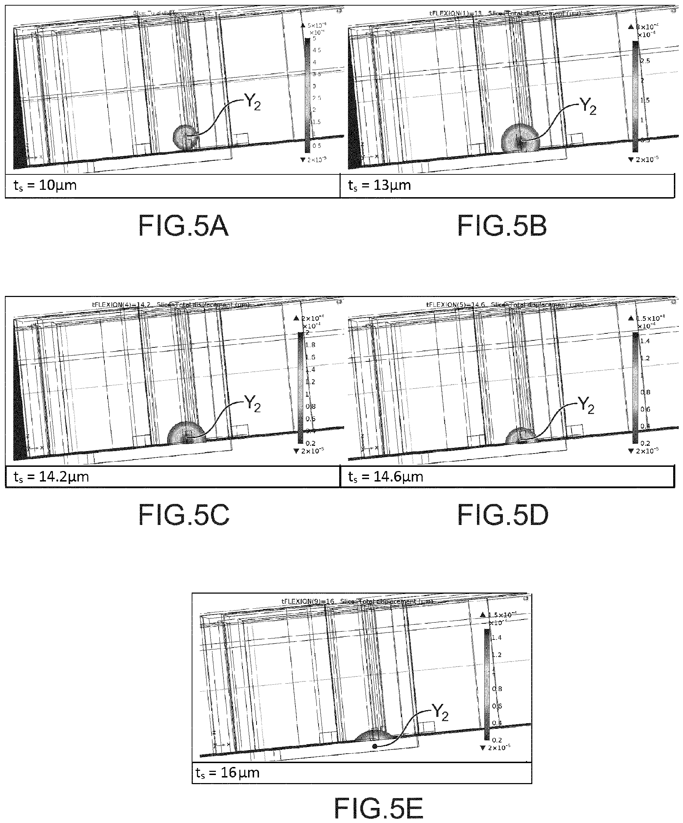

Sur les figures 5A à 5E, on peut voir représentée la position du deuxième axe pivot Y2 en fonction de l'épaisseur $t_f$ pour une masse d'épaisseur $t_M$ égale à 20 $\mu m$, pour une accélération selon la direction X de 100 g subie par une structure telle que celle de la figure 1.

Les figures 5A, 5B, 5C, 5D et 5E correspondent respectivement à des épaisseurs $t_f$ égales à 10 $\mu m$, 13 $\mu m$, 14,2 $\mu m$, 14,6 $\mu m$ et 16 $\mu m$.

On voit sur ces figures que le deuxième axe de rotation Y2 se rapproche du plan contenant les jauges et est contenu dans ce plan pour une épaisseur des poutres de flexion égale à 14,6 $\mu m$. Pour cette épaisseur, l'axe Y2 est dans la plan milieu des jauge, la somme des contraintes selon X est nulle, la sensibilité transverse $S_T$ est nulle.

Il est à noter que la sensibilité S du capteur à détection hors-plan, i.e. sa sensibilité selon la direction Z, diminue avec l'augmentation de l'épaisseur des poutres de flexion, puisque leur rigidité augmente. Il est possible de compenser cette baisse de sensibilité en augmentant la masse sismique. Cette augmentation est obtenue soit en augmentant la surface de la masse, i.e. ses dimensions dans le plan et/ou en utilisant un matériau plus dense.

Sur la figure 7, on peut voir la variation de la masse sismique normalisée M en fonction de l'épaisseur $t_f$ des poutres de flexion à sensibilité constante. Par exemple, par rapport à une structure ayant des poutres de flexion d'épaisseur 10 $\mu m$ et une masse normalisée 1, pour conserver la même sensibilité avec des poutres de flexion de 15 $\mu m$ d'épaisseur, la masse est de 1,8.

Des exemples de procédé de réalisation de capteur à détection hors-plan à sensibilité transverse maîtrisée vont maintenant être décrits.

Lors de la conception du capteur, la sensibilité transverse $S_T$ souhaitée est fixée et les dimensions de la structure, notamment l'épaisseur de la masse et des poutres de flexion sont déterminée. On cherche donc à réaliser un capteur avec une masse d'épaisseur $t_M$ et une ou des poutres de flexion d'épaisseur $t_f$ tels que la relation (3) soit vérifiée.

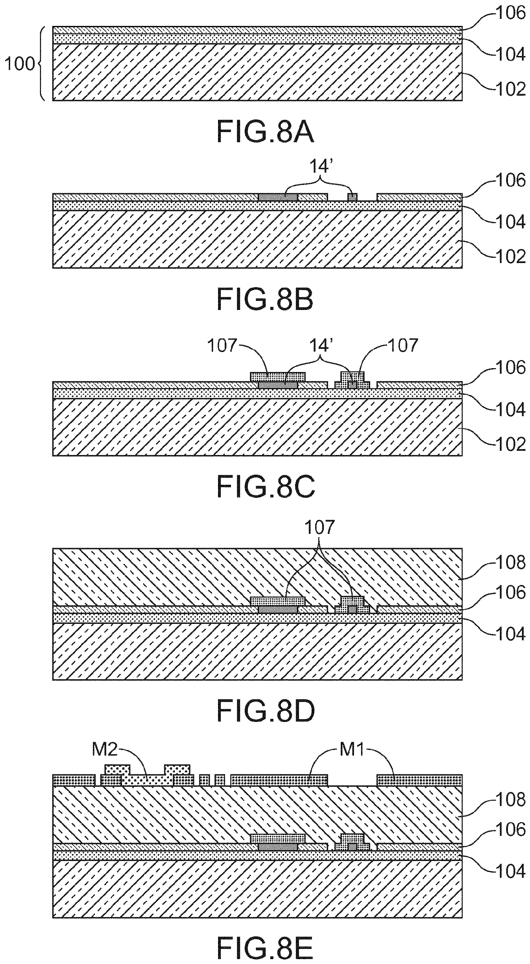

Sur les figures 8A à 8I, on peut voir les éléments obtenus à différentes étapes de réalisation d'un procédé de réalisation selon un premier exemple de réalisation.

On utilise un substrat silicium sur isolant 100 ou SOI (Silicon on Insulate en terminologie anglo-saxonne) comportant une couche de silicium support 102, une couche d'isolant électrique 104 et une couche de silicium 106.

Le substrat 100 est représenté sur la figure 8A.

Lors d'une première étape, on réalise les jauges de contrainte. Par exemple, on réalise une implantation du silicium de la couche 106 afin d'ajuster la résistance et le coefficient piézorésistif des jauges. Ensuite la couche 106 est structurée pour former les jauges, par exemple par photolithographie et gravure. Les jauges 14 ont des dimensions nanométriques.

L'élément ainsi obtenu est représenté sur la figure 8B.

Lors d'une étape suivante, on protège les jauges, par exemple par le dépôt d'une couche d'oxyde 107, par exemple une couche d'oxyde de silicium.

L'élément ainsi obtenu est représenté sur la figure 8C.

Lors d'une étape suivante, on forme une couche de silicium 108 sur la couche de silicium 106 afin d'obtenir une épaisseur de silicium égale à l'épaisseur souhaitée $t_M$ de la masse, i.e. la somme de l'épaisseur de la couche 106 et celle de la couche 108 égale à $t_M$. L'épaisseur de la couche 106 est par exemple comprise entre 0,1 $\mu m$ et 1 $\mu m$ et

l'épaisseur de la couche 108 est par exemple comprise entre 1 μm et 2μm. De préférence, la couche 108 est formée par épitaxie. De préférence, les matériaux des couches 106 et 108 sont les mêmes.

En variante, la couche 108 est formée par collage moléculaire d'un substrat, par exemple silicium, suivi d'un amincissement.

L'élément ainsi obtenu est représenté sur la figure 8D.

Lors d'une étape suivante, on réalise un premier masque M1, par exemple en oxyde, destiné à définir la structure, notamment la masse 4, et un deuxième masque M2, par exemple en résine sur l'emplacement de la ou des poutres de flexion.

L'élément ainsi obtenu est représenté sur la figure 8E.

Lors d'une étape suivante, on structure les couches de silicium des couches 106 et 108 pour former la structure, notamment la masse, et pour accéder aux jauges, par exemple par gravure profonde, par exemple par gravure ionique réactive profonde ou DRIE (Deep Reactive Ion Etching en terminologie anglo-saxonne).

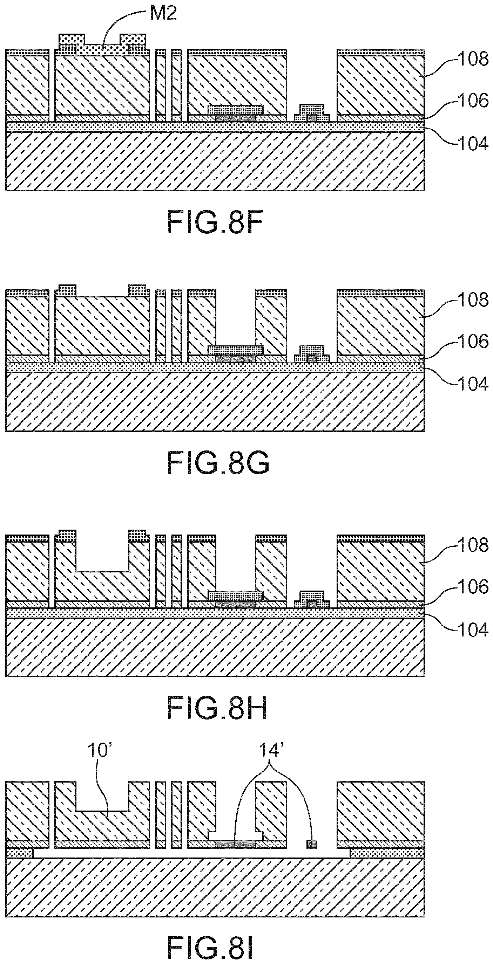

L'élément ainsi obtenu est représenté sur la figure 8F.

Lors d'une étape suivante, on retire le deuxième masque M2.

L'élément ainsi obtenu est représenté sur la figure 8G.

Lors d'une étape suivante, on amincit la couche 108 au niveau de l'emplacement de la ou des poutres de flexion, i.e. au droit de l'emplacement du deuxième masque M2. La couche 108 est amincie jusqu'à ce que l'épaisseur totale de la couche 106 et de la couche 108 amincie soit égale à la valeur $t_f$ déterminée lors la conception du capteur à partir de la relation (3) pour une valeur de sensibilité transverse donnée.

L'amincissement est au temps par exemple par gravure ionique réactive profonde ou DRIE (Deep Reactive Ion Etching en terminologie anglo-saxonne). Le temps d'amincissements est calibré.

L'élément ainsi obtenu est représenté sur la figure 8H.

Lors d'une étape suivante, on libère la structure en retirant la couche d'oxyde 104 sous la masse, les poutres et les jauges, le premier masque M1 et la couche de protection 107 des jauges sont avantageusement retirés simultanément. La libération est par exemple réalisée par gravure HF.

L'élément ainsi obtenu est représenté sur la figure 8I.

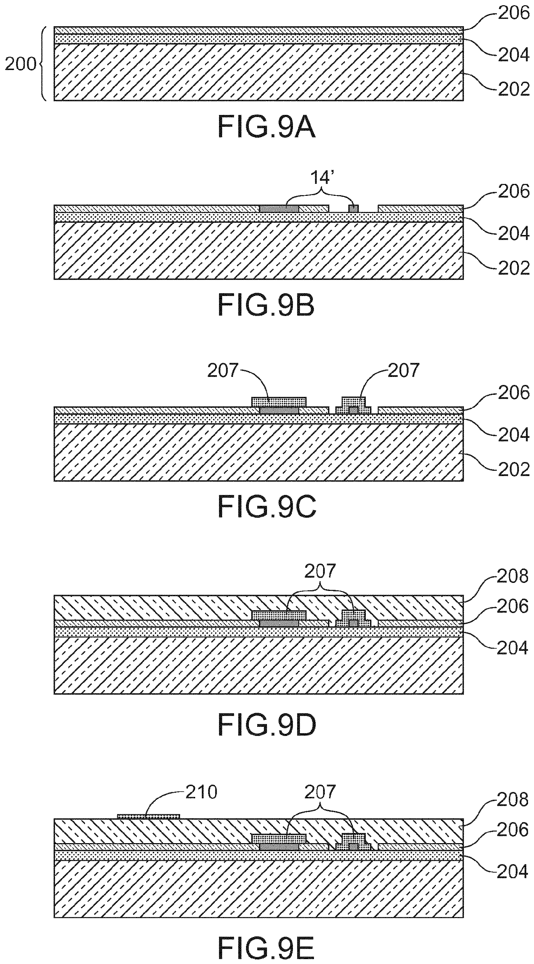

Sur les figures 9A à 9K, on peut voir représentées différentes étapes d'un autre exemple de procédé de réalisation d'un capteur à détection hors plan selon l'invention, offrant une plus grande précision dans la fixation de l'épaisseur des poutres de flexion.

On utilise un substrat silicium sur isolant 200 ou SOI (Silicon on Insulate en terminologie anglo-saxonne) comportant une couche de silicium support 202, une couche d'isolant électrique 204 et une couche de silicium 206.

Le substrat 200 est représenté sur la figure 9A.

Lors d'une première étape, on réalise les jauges de contrainte. Par exemple, on réalise une implantation du silicium de la couche 206 afin d'ajuster la résistance et le coefficient piézorésistif des jauges. Ensuite la couche 206 est structurée pour former les jauges, par exemple par photolithographie et gravure. Les jauges 14' ont des dimensions nanométriques.

L'élément ainsi obtenu est représenté sur la figure 9B.

Lors d'une étape suivante, on protège les jauges, par exemple par le dépôt d'une couche d'oxyde 207, par exemple une couche d'oxyde de silicium.

L'élément ainsi obtenu est représenté sur la figure 9C.

Lors d'une étape suivante, on forme une couche de silicium 208 sur la couche 206 de sorte que l'épaisseur formée par la couche 206 et de la couche 208 soit égale à l'épaisseur $t_f$ souhaitée. La couche 208 est formée par exemple par épitaxie.

L'élément ainsi obtenu est représenté sur la figure 9D.

Lors d'une étape suivante, on forme une couche d'arrêt, par exemple une couche d'oxyde et ensuite on la structure, par exemple par gravure, de sorte à ne conserver qu'une portion d'arrêt 210 à l'aplomb de l'emplacement de la ou des poutres de flexion. La couche d'oxyde est similaire à la couche d'oxyde 207 formée pour protéger les jauges.

L'élément ainsi obtenu est représenté sur la figure 9E.

Lors d'une étape suivante, on forme une couche de silicium 212 sur la couche de silicium 208 et sur la portion d'arrêt Z10, par exemple par épitaxie. L'épaisseur de la couche 212 est telle que la somme des épaisseurs de couches 206, 208 et 112 est égale à l'épaisseur $t_M$ de la masse souhaitée.

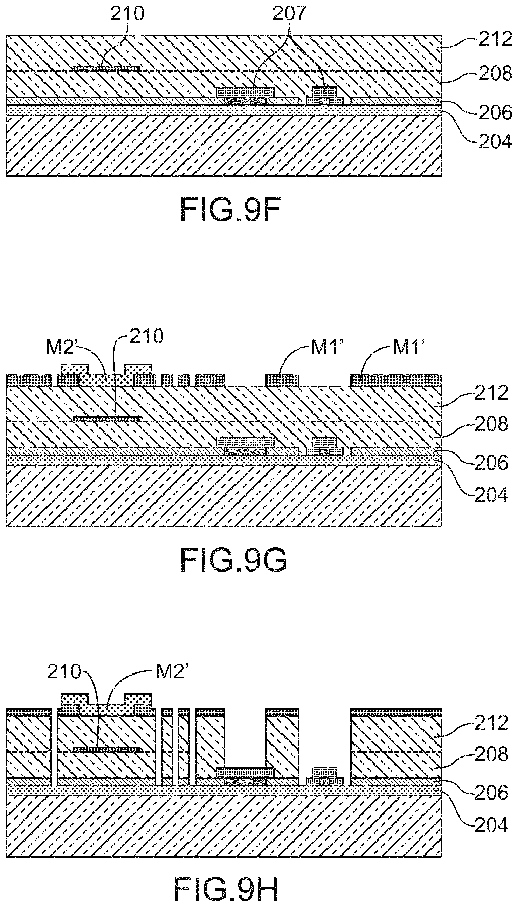

L'élément ainsi obtenu est représenté sur la figure 9F.

Lors d'une étape suivante, on réalise un premier masque M1', par exemple en oxyde, destiné à définir la structure, notamment la masse, et un deuxième masque M2', par exemple en résine sur l'emplacement de la ou des poutres de flexion.

L'élément ainsi obtenu est représenté sur la figure 9G.

Lors d'une étape suivante, on structure les couches de silicium des couches 206, 208 et 212 pour former la structure, notamment la masse, et pour accéder aux jauges, par exemple par gravure profonde, par exemple par gravure

# EP 3 632 838 B1

ionique réactive profonde ou DRIE (Deep Reactive Ion Etching en terminologie anglo-saxonne).

L'élément ainsi obtenu est représenté sur la figure 9H.

Lors d'une étape suivante, on retire le deuxième masque M2'.

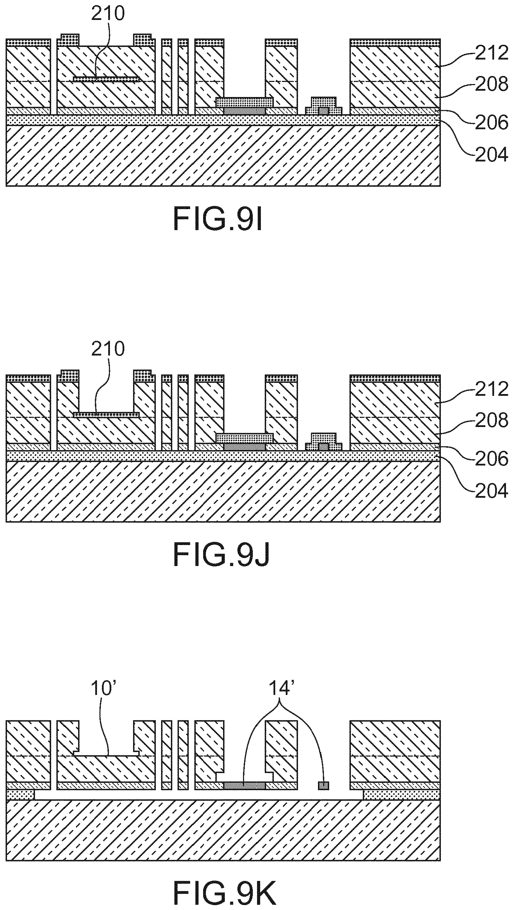

L'élément ainsi obtenu est représenté sur la figure 9I.

Lors d'une étape suivante, on grave la couche 212 jusqu'à atteindre la portion d'arrêt 210 au niveau de l'emplacement de la ou des poutres de flexion, i.e. au droit de l'emplacement du deuxième masque M2'.

L'élément ainsi obtenu est représenté sur la figure 9J.

Lors d'une étape suivante, on libère la structure en retirant la couche d'oxyde 204 sous la masse, les poutres et les jauges, le premier masque M1, la couche de protection 207 des jauges et la portion d'arrêt 210 sont avantageusement retirés simultanément. La libération est par exemple réalisée par gravure HF.

L'élément ainsi obtenu est représenté sur la figure 9K.

L'épaisseur de la ou des poutres de flexion est définie plus précisément par le procédé de figures 9A à 9K.

La structure peut être réalisée en un autre matériau semi-conducteur que le silicium, elle peut être réalisée par exemple le SiGe, SiC.

Il sera également compris que le substrat 100 peut être réalisé lors du procédé de fabrication.

## Revendications

1. Capteur microélectromécanique à détection hors-plan présentant une sensibilité transverse dans une première direction (X) dans le plan de valeur $S_T$, ledit capteur comportant un support (2), une masse inertielle (4) suspendue au support (2) par des moyens de suspension, un premier axe de rotation autour duquel la masse inertielle (4) pivote par rapport au support (2) dans une direction hors-plan lorsque le capteur est soumis à une contrainte dans la direction hors-plan, lesdits moyens de suspension comportant au moins une première poutre (10) dans le plan, ladite au moins une première poutre (10) étant ancrée par une extrémité longitudinale au support et par une autre extrémité longitudinale à la masse inertielle (4), de sorte que lors d'un déplacement de la masse inertielle (4) dans la direction hors-plan (Z), ladite au moins première poutre (10) soit sollicitée en flexion, et des moyens de détection du déplacement de la masse dans la direction hors plan, lesdits moyens de détection comportant au moins une première jauge de contrainte (14) suspendue par une première extrémité à la masse inertielle (4) et par une deuxième extrémité au support et s'étendant parallèlement à ladite au moins une première poutre (10), dans lequel ladite au moins première poutre (10) a une dimension $t_f$ dans la direction hors-plan (Z) et la masse inertielle (4) a une dimension $t_M$ dans la direction hors-plan (Z),
   **caractérisé en ce que** la dimension $t_f$ est égale à

   $$t_f = \frac{3}{4}(t_M - 2l_{arm}S_T).$$

   $l_{arm}$ étant la distance entre le centre de gravité (C) de la masse inertielle et le centre de la au moins une première poutre projeté sur la première direction (X).

2. Capteur microélectromécanique selon la revendication 1, dans lequel la dimension dans la direction hors-plan tf de la première poutre est choisie égale à 3/4 de la dimension dans la direction hors-plan $t_M$ de la masse de sorte que le capteur présente une sensibilité transverse de valeur $S_T$ nulle ou quasiment nulle.

3. Capteur microélectromécanique selon la revendication 1 ou 2, dans lequel les moyens de suspension comportent au moins deux premières poutres (10,).

4. Capteur microélectromécanique selon la revendication 1, 2 ou 3, dans lequel les moyens de suspension comportent au moins une deuxième poutre (8) et destinée à être sollicitée en torsion lors du déplacement de la masse inertielle (4) dans la direction hors-plan (Z).

5. Capteur microélectromécanique selon l'une des revendications précédentes, dans lequel le capteur comporte un deuxième axe de rotation (Y2) autour duquel la masse inertielle (4) pivote par rapport au support (2) dans une direction hors-plan lorsque le capteur est soumis à une contrainte dans la direction dans le plan et dans lequel ledit deuxième axe de rotation (Y2) est situéé dans le plan milieu de la première jauge (14).

6. Capteur microélectromécanique selon l'une des revendications précédentes, dans lequel la sensibilité transverse est comprise dans l'intervalle [-1% ; +1%].

7. Capteur microélectromécanique selon l'une des revendications 1 à 6, dans lequel les moyens de détection comportent une deuxième jauge de contrainte suspendue et disposé par rapport à la première jauge (14) de sorte à permettre une mesure différentielle.

8. Procédé de fabrication d'un capteur selon l'une des revendications 1 à 7, comportant :

- la réalisation d'au moins une première jauge de contrainte dans une première couche conductrice électrique ou semi-conductrice (106), formée sur une couche d'arrêt (104) formée sur une couche support (102),
- la formation d'un couche de protection (107) uniquement sur ladite au moins une première jauge de contrainte,
- la formation d'une deuxième couche conductrice électrique ou semi-conductrice (108) sur la première couche (106) et sur la couche de protection (107), de sorte que l'épaisseur de la première couche (106) et de la deuxième couche '108soit égale à l'épaisseur de la masse inertielle $t_M$,
- la formation d'un premier masque (M1) pour définir la masse inertielle,
- la formation d'un deuxième masque (M2) à l'aplomb de l'emplacement de la au moins première poutre,
- la structuration des première (106) et deuxième (108) couches conductrices électriques ou semi-conductrices de sorte à délimiter la masse inertielle et atteindre la couche de protection de la au moins une première jauge,
- le retrait du deuxième masque (M2),
- l'amincissement de la deuxième couche conductrice électrique ou semi-conductrice (108) de sorte à retirer une épaisseur de matériau conducteur ou semi-conducteur égale à $t_M - t_f$,
- la libération de la masse inertielle, de la au moins une première jauge et de la au moins première poutre.

9. Procédé de fabrication d'un capteur selon l'une des revendications 1 à 7, comportant :

- la réalisation d'au moins une première jauge de contrainte dans une première couche conductrice électrique ou semi-conductrice (206), formée sur une couche d'arrêt (204) formée sur une couche support (202),
- la formation d'un couche de protection (207) uniquement sur ladite au moins une première jauge de contrainte,
- la formation d'une deuxième couche conductrice électrique ou semi-conductrice (208) sur la première couche (206) et sur la couche de protection (207), de sorte que l'épaisseur de la première couche (206) et de la deuxième couche (208) soit égale à l'épaisseur de la première poutre $t_f$,
- la formation d'une portion d'arrêt (210) sur la deuxième couche conductrice électrique ou semi-conductrice (208) à l'aplomb de l'emplacement de la au moins première poutre,
- la formation d'une troisième couche conductrice électrique ou semi-conductrice (212) sur la deuxième couche conductrice électrique ou semi-conductrice (206) et sur la portion d'arrêt (210), de sorte que l'épaisseur de la première (206), de la deuxième (208) et de la troisième (210) couche soit égale à l'épaisseur de la masse inertielle $t_M$,
- la formation d'un premier masque (M1') pour définir la masse inertielle et un deuxième masque (M2') à l'aplomb de la portion d'arrêt (210),
- la structuration des première (206), deuxième (208) et troisième couches (212) conductrices électriques ou semi-conductrices de sorte à délimiter la masse inertielle et atteindre la couche de protection (207) de la au moins une première jauge,
- le retrait du deuxième masque (M2'),
- l'amincissement de la deuxième couche conductrice électrique ou semi-conductrice (208) de sorte à retirer une épaisseur de matériau conducteur ou semi-conducteur égale à $t_M - t_f$,
- la libération de la masse inertielle, de la au moins une première jauge et de la au moins première poutre.

10. Procédé de fabrication selon la revendication 8 ou 9, dans lequel le premier masque (M1, M1') est en oxyde et le deuxième masque est en résine.

11. Procédé de fabrication selon l'une des revendications 8 à 10, dans lequel la deuxième couche (108, 208) et la troisième couche (212) sont formées par épitaxie.


**Patentansprüche**

1. Mikroelektromechanischer Sensor zur Out-of-plane-Erfassung mit einer Querempfindlichkeit in einer ersten Richtung (X) in der Ebene des Wertes $S_T$, wobei der Sensor einen Träger (2), eine Trägheitsmasse (4), die über Aufhängungsmittel an dem Träger (2) aufgehängt ist, eine erste Drehachse, um die die Trägheitsmasse (4) relativ zum Träger (2) in einer Richtung außerhalb der Ebene schwenkt, wenn der Sensor einer Beanspruchung in der Richtung außerhalb der Ebene ausgesetzt wird, enthält, wobei die Aufhängungsmittel zumindest einen ersten Balken (10) in der Ebene umfassen, wobei der zumindest eine erste Balken (10) mit einem Längsende am Träger und mit einem anderen Längsende an der Trägheitsmasse (4) verankert ist, so dass bei einer Verschiebung der Trägheitsmasse (4) in der Richtung (Z) außerhalb der Ebene der zumindest eine erste Balken (10) auf Biegung beansprucht wird, sowie Mittel zum Erfassen der Verschiebung der Masse in der Richtung außerhalb der Ebene, wobei die Erfassungsmittel zumindest einen ersten Dehnungsmessstreifen (14) aufweisen, der mit einem ersten Ende an der Trägheitsmasse (4) und mit einem zweiten Ende an dem Träger aufgehängt ist und sich parallel zu dem zumindest einen ersten Balken (10) erstreckt, wobei der zumindest eine erste Balken (10) eine Abmessung tf in der Richtung (Z) außerhalb der Ebene hat und die Trägheitsmasse (4) eine Abmessung $t_M$ in der Richtung (Z) außerhalb der Ebene hat,

**dadurch gekennzeichnet, dass** die Abmessung tf gleich

$$t_f = \frac{3}{4}\left(t_M - 2l_{arm}S_T\right)$$

ist, wobei $l_{arm}$ der Abstand zwischen dem Schwerpunkt (C) der Trägheitsmasse und dem Mittelpunkt des zumindest einen ersten Balkens, projiziert auf die erste Richtung (X), ist.

2. Mikroelektromechanischer Sensor nach Anspruch 1, wobei die Abmessung in der Richtung außerhalb der Ebene tf des ersten Balkens so gewählt ist, dass sie 3/4 der Abmessung in der Richtung außerhalb der Ebene $t_M$ der Masse beträgt, so dass der Sensor eine Querempfindlichkeit mit dem Wert $S_T$ Null oder nahezu Null aufweist.

3. Mikroelektromechanischer Sensor nach Anspruch 1 oder 2, wobei die Aufhängungsmittel zumindest zwei erste Balken (10,) aufweisen.

4. Mikroelektromechanischer Sensor nach Anspruch 1, 2 oder 3, wobei die Aufhängungsmittel zumindest einen zweiten Balken (8) aufweisen, der dazu bestimmt ist, bei der Verschiebung der Trägheitsmasse (4) in der Richtung außerhalb der Ebene (Z) auf Torsion beansprucht zu werden.

5. Mikroelektromechanischer Sensor nach einem der vorhergehenden Ansprüche, wobei der Sensor eine zweite Drehachse (Y2) aufweist, um die die Trägheitsmasse (4) relativ zum Träger (2) in einer Richtung außerhalb der Ebene schwenkt, wenn der Sensor in der Richtung in der Ebene beansprucht wird, und wobei die zweite Drehachse (Y2) in der Mittelebene des ersten Messstreifens (14) liegt.

6. Mikroelektromechanischer Sensor nach einem der vorhergehenden Ansprüche, wobei die Querempfindlichkeit im Bereich [-1%; +1%] liegt.

7. Mikroelektromechanischer Sensor nach einem der Ansprüche 1 bis 6, wobei die Erfassungsmittel einen zweiten Dehnungsmessstreifen aufweisen, der relativ zum ersten Messstreifen (14) aufgehängt und so angeordnet ist, dass er eine Differenzmessung ermöglicht.

8. Verfahren zum Herstellen eines Sensors nach einem der Ansprüche 1 bis 7, umfassend:

  - Herstellen zumindest eines ersten Dehnungsmessstreifens in einer ersten elektrisch leitenden oder halbleitenden Schicht (106), die auf einer auf einer Trägerschicht (102) ausgebildeten Sperrschicht (104) ausgebildet ist,
  - Ausbilden einer Schutzschicht (107) nur an dem zumindest einen ersten Dehnungsmessstreifen,
  - Ausbilden einer zweiten elektrisch leitenden oder halbleitenden Schicht (108) auf der ersten Schicht (106) und auf der Schutzschicht (107), derart, dass die Dicke der ersten Schicht (106) und zweiten Schicht (108) gleich der Dicke der Trägheitsmasse $t_M$ ist,
  - Ausbilden einer ersten Maske (M1) zum Definieren der Trägheitsmasse,
  - Ausbilden einer zweiten Maske (M2) lotrecht zur Stelle des zumindest einen ersten Balkens,
  - Strukturieren der ersten (106) und zweiten (108) elektrisch leitenden oder halbleitenden Schicht, um die Trägheitsmasse zu begrenzen und die Schutzschicht des zumindest einen ersten Messstreifens zu erreichen,
  - Entfernen der zweiten Maske (M2),
  - Ausdünnen der zweiten elektrisch leitenden oder halbleitenden Schicht (108), um eine Dicke des leitenden oder halbleitenden Materials zu entfernen, die gleich t$_M$ - t$_f$ ist,
- Freigeben der Trägheitsmasse, des zumindest einen ersten Messstreifens und des zumindest einen ersten Balkens.

9. Verfahren zum Herstellen eines Sensors nach einem der Ansprüche 1 bis 7, umfassend:

- Herstellen zumindest eines ersten Dehnungsmessstreifens in einer ersten elektrisch leitenden oder halbleitenden Schicht (206), die auf einer auf einer Trägerschicht (202) ausgebildeten Sperrschicht (204) ausgebildet ist,
- Ausbilden einer Schutzschicht (207) nur an dem zumindest einen ersten Dehnungsmessstreifen,
- Ausbilden einer zweiten elektrisch leitenden oder halbleitenden Schicht (208) auf der ersten Schicht (206) und auf der Schutzschicht (207), derart, dass die Dicke der ersten Schicht (206) und der zweiten Schicht (208) gleich der Dicke des ersten Balkens t$_f$ ist,
- Ausbilden eines Sperrabschnitts (210) auf der zweiten elektrisch leitenden oder halbleitenden Schicht (208) lotrecht zu der Stelle des zumindest einen ersten Balkens,
- Ausbilden einer dritten elektrisch leitenden oder halbleitenden Schicht (212) auf der zweiten elektrisch leitenden oder halbleitenden Schicht (206) und auf dem Sperrabschnitt (210), derart, dass die Dicke der ersten (206), der zweiten (208) und der dritten Schicht (210) gleich der Dicke der Trägheitsmasse t$_M$ ist,
- Ausbilden einer ersten Maske (M1') zum Definieren der Trägheitsmasse und einer zweiten Maske (M2') lotrecht zum Sperrabschnitt (210),
- Strukturieren der ersten (206), der zweiten (208) und der dritten (212) elektrisch leitenden oder halbleitenden Schicht, um die Trägheitsmasse zu begrenzen und die Schutzschicht (207) des zumindest einen ersten Messstreifens zu erreichen,
- Entfernen der zweiten Maske (M2'),
- Ausdünnen der zweiten elektrisch leitenden oder halbleitenden Schicht (208), um eine Dicke des leitenden oder halbleitenden Materials zu entfernen, die gleich t$_M$ - t$_f$ ist,
- Freigeben der Trägheitsmasse, des zumindest einen ersten Messstreifens und des zumindest einen ersten Balkens.

10. Herstellungsverfahren nach Anspruch 8 oder 9, wobei die erste Maske (M1, M1') aus Oxid und die zweite Maske aus Harz besteht.

11. Herstellungsverfahren nach einem der Ansprüche 8 bis 10, wobei die zweite Schicht (108, 208) und die dritte Schicht (212) durch Epitaxie gebildet werden.

**Claims**

1. Microelectromechanical sensor with an out-of-plane detection having a cross sensitivity in a first direction (X) in the plane with a value S$_T$, said sensor comprising a support (2), an inertial mass (4) suspended from the support (2) by suspension means, a first axis of rotation about which the inertial mass (4) pivots with respect to the support (2) in an out-of-plane direction when the sensor is subjected to a stress in the out-of-plane direction, said suspension means comprising at least one first beam (10) in the plane, said at least one first beam being anchored by a longitudinal end to the support and by another longitudinal end to the inertial mass (4), in such a way that during a movement of the inertial mass (4) in the out-of-plane direction (Z), said at least first beam (10) is stressed by bending, and means for detection of the movement of the mass in the out-of-plane direction, said detection means comprising at least one first stress gauge (14) suspended by a first end from the inertial mass (4) and by a second end from the support and extending in parallel to said at least one first beam (10), wherein said to the first beam (10) has a dimension t$_f$ in the out-of-plane direction (Z) and the inertial mass (4) has a dimension t$_M$ in the out-of-plane direction (Z) such that

$$t_f = \frac{3}{4}(t_M - 2l_{arm}S_T).$$

l$_{arm}$ being the distance between the centre of gravity (C) of the inertial mass and the centre of the at least one first beam projected onto the first longitudinal direction (X).

2. Microelectromechanical sensor according to claim 1, wherein the dimension in the out-of-plane direction tf of the first beam is chosen as equal to 3/4 of the dimension in the out-of-plane direction $t_M$ of the mass in such a way that the sensor has a cross sensitivity with a value $S_T$ of zero or almost zero.

3. Microelectromechanical sensor according to claim 1 or 2, wherein the suspension means comprise at least two first beams (10).

4. Microelectromechanical sensor according to claim 1, 2 or 3, wherein the suspension means comprise at least one second beam (8) and intended to be stressed in torsion during the movement of the inertial mass (4) in the out-of-plane direction (Z).

5. Microelectromechanical sensor according to one of the previous claims, wherein the sensor comprises a second axis of rotation (Y2) about which the inertial mass (4) pivots with respect to the support (2) in an out-of-plane direction when the sensor is subjected to a stress in the direction in the plane and wherein said second axis of rotation (Y2) is located in the middle plane of the first gauge (14).

6. Microelectromechanical sensor itself according to one of the previous claims, wherein the cross sensitivity is comprised in the interval [-1%; +1%].

7. Microelectromechanical sensor according to one of the claims 1 to 6, wherein the detection means comprise a second stress gauge suspended and disposed with respect to the first gauge (14) in such a way as to allow a differential measurement.

8. Method for manufacturing a sensor according to one of the claims 1 to 7, comprising:

   - the realisation of at least one first stress gauge in a first electrically conductive or semiconductor layer (106), formed on a barrier layer (104) formed on a support layer (1°2),
   - the formation of a protective layer (107)only on said at least one first stress gauge,
   - the formation of a second electrically conductive or semiconductor (108) layer on the first layer (106) and on the protective layer (107), in such a way that the thickness of the first layer (106) and of the second layer (108) is equal to the thickness of the inertial mass $t_M$,
   - the formation of a first mask (M1) in order to define the inertial mass,
   - the formation of a second mask (M2) vertically aligned with the location of the at least first beam,
   - the structuration of the first (106) and second (108) electrically conductive or semiconductor layers in such a way as to define the inertial mass and reach the protective layer of the at least one first gauge,
   - the removal of the second mask (M2),
   - the thinning of the second electrically conductive or semiconductor layer (108) in such a way as to remove a thickness of conductive or semiconductor material equal to $t_M - t_f$,
   - the releasing of the inertial mass, of the at least one first gauge and of the at least first beam.

9. Method for manufacturing of an according to one of the claims 1 to 7, comprising:

   - the realisation of at least one first stress gauge in a first electrically conductive or semiconductor layer (206), formed on a barrier layer 204) formed on a support layer (202),
   - the formation of a protective layer (207) only on said at least one first stress gauge,
   - the formation of a second electrically conductive or semiconductor layer (208) on the first layer (206) and on the protective layer (207), in such a way that the thickness of the first layer (206) and of the second layer (208) is equal to the thickness of the first beam $t_f$,
   - the formation of a barrier portion (210) on the second electrically conductive or semiconductor layer (208) vertically aligned with the location of the at least first beam,
   - the formation of a third electrically conductive or semiconductor layer (212) on the second electrically conductive or semiconductor layer (206) and on the barrier portion (210), in such a way that the thickness of the first (206), of the second (208) and of the third layer (210) is equal to the thickness of the inertial mass $t_M$,
   - the formation of a first mask (M1') in order to define the inertial mass and a second mask (M2') vertically aligned with the barrier portion (210),
   - the structuration of the first (206) second (208) and third (212) electrically conductive or semiconductor layers in such a way as to define the inertial mass and reach the protective layer (207) of the at least one first gauge,
   - the removal of the second mask (M2'),

- the thinning of the second electrically conductive or semiconductor layer (208) in such a way as to remove a thickness of conductive or semiconductor material equal to $t_M - t_f$,
- the releasing of the inertial mass, of the at least one first gauge and of the at least first beam.

**10.** Manufacturing method according to claim 8 or 9, wherein the first mask (M1, M1') is made of oxide and the second mask is made of resin.

**11.** Manufacturing method according to one of the claims 8 to 10, wherein the second layer (108, 208) and the third layer (212) are formed by epitaxy.

Y1;Y2  12

14

10

Y
↑
Z ⊙ →X

2

8

2

8

2

10

12

14

4

FIG.1

10

Y1

Z
↑
Y ⊗ →X

4

2

14

Y2

FIG.2

FIG.3

FIG.4

$t_s = 10\mu m$

FIG.5A

$t_s = 13\mu m$

FIG.5B

$t_s = 14.2\mu m$

FIG.5C

$t_s = 14.6\mu m$

FIG.5D

$t_s = 16\mu m$

FIG.5E

FIG.6

FIG.7

FIG.8A

FIG.8B

FIG.8C

FIG.8D

FIG.8E

M2

108
106
104

FIG.8F

108
106
104

FIG.8G

108
106
104

FIG.8H

10'

14'

FIG.8I

206
204
200
202

FIG.9A

14'
206
204
202

FIG.9B

207 — — 207
206
204
202

FIG.9C

207
208
206
204

FIG.9D

210 207
208
206
204

FIG.9E

FIG.9F

FIG.9G

FIG.9H

210

212
208
206
204

**FIG.9I**

210

212
208
206
204

**FIG.9J**

10'          14'

**FIG.9K**

**EP 3 632 838 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3000050

- EP 2211185 A